(19) Europäisches Patentamt
European Patent Office
Office européen des brevets

(11) **EP 3 633 398 A1**

(12) **EUROPEAN PATENT APPLICATION**

(43) Date of publication:
08.04.2020 Bulletin 2020/15

(51) Int Cl.:
*G01R 33/00* (2006.01)   *G01R 33/10* (2006.01)
*G01V 3/08* (2006.01)   *G01V 3/165* (2006.01)
*G01R 33/02* (2006.01)   *G01R 33/022* (2006.01)

(21) Application number: 19198020.0

(22) Date of filing: 18.09.2019

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 05.10.2018 TW 107135296
05.10.2018 TW 107213565 U
11.09.2019 TW 108132837

(71) Applicant: **National Central University
Taoyuan City (TW)**

(72) Inventors:
• **CHEN, Chien-Chih**
**Taoyuan City (TW)**
• **CHU, Yi-Chen**
**Taoyuan City (TW)**
• **CHUANG, Yung-Chieh**
**Taoyuan City (TW)**

(74) Representative: **Banse & Steglich
Patentanwälte PartmbB
Patentanwaltskanzlei
Herzog-Heinrich-Straße 23
80336 München (DE)**

(54) **APPARATUS AND METHOD FOR SCANNING AN ARTIFICIAL STRUCTURE**

(57) A method for scanning artificial structure, wherein a scanning artificial structure apparatus comprises four magnetic-field sensors, the four magnetic-field sensors are non-coplanar configured, the method comprises following steps of: moving the scanning artificial structure apparatus along a scanning path within a to-be-tested area, in the meantime, measuring magnetic field by the four magnetic-field sensors, and recording a position sequence when measuring magnetic field, wherein four magnetic-field measurement sequences are measured by the four magnetic-field sensors; and calculating a magnetic-field variation distribution from the four magnetic-field measurement sequences and the position sequence, wherein the magnetic-field variation distribution is corresponding to at least one artificial structure distribution.

Fig. 3

**Description**

**Field of the invention**

The present invention is related to an apparatus and method for scanning artificial structure, especially an apparatus with at least four non-coplanar configured magnetic field sensors and method for scanning artificial structure.

**Background of the invention**

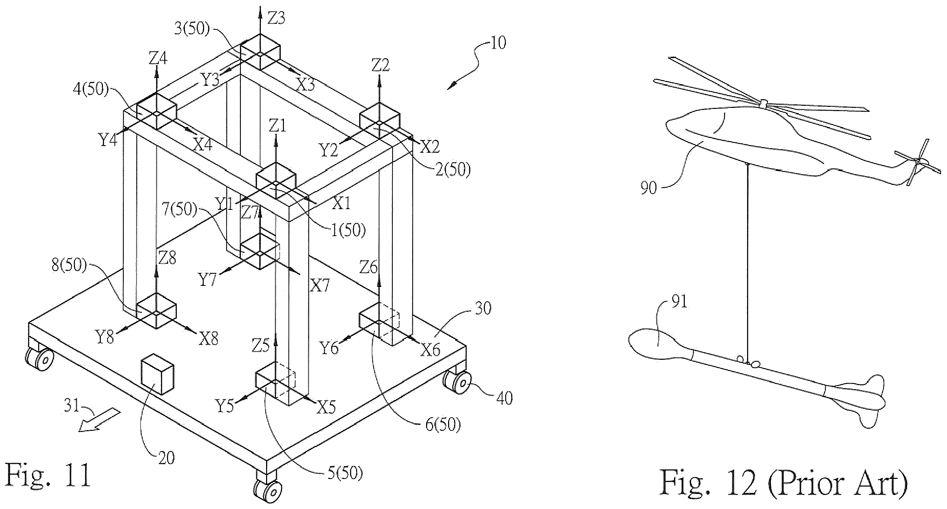

Please refer to Figure 12, which is a schematic view showing the conventional technology measuring the magnetic field. The conventional technology is applied to accurately measure a geomagnetic field **BEarth** (vector field) (hereinafter, referred to as **"BEarth"**). However, since measuring magnetic field is very easily interfered, the conventional technology suspends a precision magnetic field measuring instrument 91 under a helicopter 90, and the precision magnetic field measuring instrument 91 is suspended by the helicopter 90 to perform magnetic field measurement in the area to be tested. The length of the suspension should be long enough to prevent the measurement data of the precision magnetic field measuring instrument 91 from interfered by the inductive magnetic field of the helicopter 90. And the high precision magnetic field measuring instrument 91 is required to accurately measure the magnetic field. It costs a lot. However, the artificial structure on the ground generates an artificial structure magnetic field **BArtificial** (vector field) (hereinafter, referred to as **"BArtificial"**) due to induction. Especially when the artificial structure includes a material with a conductor, it is more likely to generate the **BArtificial** due to induction. Therefore, in the conventional technology, when measuring the magnetic field, the precision magnetic field measuring instrument needs to have a certain height from the ground to avoid the influence of the **BArtificial** generated by some objects on the ground, especially the artificial structure.

Generally, when carrying out road pavement excavation or excavation work in some construction areas, it is often encountered that some pipelines are accidentally dug. Occasionally, it is very dangerous to accidentally dig into a gas pipeline. How to find out whether there are pipelines in the underground before construction mining, this has always been an unsolvable problem. Although conventional technology can measure the magnetic field very accurately, the magnetic field measurement (vector) measured by the high precision magnetic field measuring instrument 91 of conventional technology is the sum of the **BArtificial** and the **BEarth** of the measured position. However conventional technology cannot tell from the magnitude and the direction of the component of the **BEarth** and the magnitude and the direction of the component of the **BArtificial** of the magnetic field measurement (vector) measured by the high precision magnetic field measuring instrument 91. Hence conventional technology cannot be applied to measure the **BArtificial** generated by the artificial structure under the ground, therefore, it cannot be applied to measure the structure of artificial structure under the ground.

Accordingly, the present invention has developed a new design which may avoid the above mentioned drawbacks, may significantly enhance the performance of the devices and may take into account economic considerations. Therefore, the present invention then has been invented.

**Summary of the invention**

The main technical problem that the present invention is seeking to solve is to provide an apparatus and method for scanning artificial structure to scan the artificial structure under the ground to avoid excavation to the artificial structure under the ground.

In order to solve the problems mentioned the above and to achieve the expected effect, the present invention provides a method for scanning artificial structure, wherein a scanning artificial structure apparatus (hereinafter, referred to as "SASA") comprises a magnetic field sensing portion, wherein the magnetic field sensing portion comprises a first magnetic field sensor (hereinafter, referred to as "MFS"), a second magnetic field sensor (second MFS), a third magnetic field sensor (third MFS), and a fourth magnetic field sensor (fourth MFS), wherein the first MFS, the second MFS, the third MFS, and the fourth MFS are non-coplanar configured, the method comprises following steps of: Step A: moving the SASA along a scanning path within a to-be-tested area, in the meantime, measuring magnetic field by the first MFS, the second MFS, the third MFS, and the fourth MFS respectively, and recording a position sequence [PS] (hereinafter, referred to as "[PS]"), wherein a first magnetic field measurement sequence **[BUC1]** (hereinafter, referred to as **"[BUC1]"**) is measured by the first MFS, a second magnetic field measurement sequence **[BUC2]** (hereinafter, referred to as **"[BUC2]"**) is measured by the second MFS, a third magnetic field measurement sequence **[BUC3]** (hereinafter, referred to as **"[BUC3]"**) is measured by the third MFS, and a fourth magnetic field measurement sequence **[BUC4]** (hereinafter, referred to as **"[BUC4]"**) is measured by the fourth MFS; and Step B: calculating a magnetic field variation distribution **BVarD** from the **[BUC1],** the **[BUC2],** the **[BUC3],** the **[BUC4],** and the [PS], wherein the magnetic field variation distribution **BVarD** is corresponding to at least one artificial structure distribution.

In an embodiment, the method further comprises a following step of: Step A0: measuring an instrument magnetic field **BInst** (hereinafter, referred to as "**BInst**") by the first MFS, the second MFS, the third MFS, and the fourth MFS respectively, wherein the **BInst** is generated by the SASA, wherein a first instrument magnetic field measurement **BInst1** (hereinafter, referred to as "**BInst1**") is measured by the first MFS, a second instrument magnetic field measurement **BInst2** (hereinafter, referred to as "**BInst2**") is measured by the second MFS, a third instrument magnetic field measurement **BInst3** (hereinafter, referred to as "**BInst3**") is measured by the third MFS, and a fourth instrument magnetic field measurement **BInst4** (hereinafter, referred to as "**BInst4**") is measured by the fourth MFS; wherein in the Step B, the magnetic field variation distribution **BVarD** is calculated from a subtraction of the **BInst1** from the **[BUC1]**, a subtraction of the **BInst2** from the **[BUC2]**, a subtraction of the **BInst3** from the **[BUC3]**, a subtraction of the **BInst4** from the **[BUC4]**, and the [PS]; wherein the method is executed in following sequence: (1) the Step A0, the Step A, and the Step B, or (2) the Step A, the Step A0, and the Step B.

In an embodiment, wherein the magnetic field sensing portion further comprises a fifth magnetic field sensor (fifth MFS), a sixth magnetic field sensor (sixth MFS), a seventh magnetic field sensor (seventh MFS), and an eighth magnetic field sensor (eighth MFS), wherein the Step A further comprises a following step of: measuring magnetic field by the fifth MFS, the sixth MFS, the seventh MFS, and the eighth MFS respectively during moving the SASA, wherein a fifth magnetic field measurement sequence **[BUC5]** (hereinafter, referred to as "**[BUC5]**") is measured by the fifth MFS, a sixth magnetic field measurement sequence **[BUC6]** (hereinafter, referred to as "**[BUC6]**") is measured by the sixth MFS, a seventh magnetic field measurement sequence **[BUC7]** (hereinafter, referred to as "**[BUC7]**") is measured by the seventh MFS, and an eighth magnetic field measurement sequence **[BUC8]** (hereinafter, referred to as "**[BUC8]**") is measured by the eighth MFS; wherein the Step B, the magnetic field variation distribution **BVarD** is calculated from the **[BUC1]**, the **[BUC2]**, the **[BUC3]**, the **[BUC4]**, the **[BUC5]**, the **[BUC6]**, the **[BUC7]**, the **[BUC8]**, and the [PS].

In an embodiment, the method further comprises a following step of: Step A0: measuring an **BInst** by the first MFS, the second MFS, the third MFS, the fourth MFS, the fifth MFS, the sixth MFS, the seventh MFS, and the eighth MFS respectively, wherein the **BInst** is generated by the SASA, wherein a **BInst1** is measured by the first MFS, a **BInst2** is measured by the second MFS, a **BInst3** is measured by the third MFS, a **BInst4** is measured by the fourth MFS, a fifth instrument magnetic field measurement **BInstS** (hereinafter, referred to as "**BInstS**") is measured by the fifth MFS, a sixth instrument magnetic field measurement **BInst6** (hereinafter, referred to as "**BInst6**") is measured by the sixth MFS, a seventh instrument magnetic field measurement **BInst7** (hereinafter, referred to as "**BInst7**") is measured by the seventh MFS, and an eighth instrument magnetic field measurement **BInst8** (hereinafter, referred to as "**BInst8**") is measured by the eighth MFS; wherein in the Step B, the magnetic field variation distribution **BVarD** is calculated from a subtraction of the **BInst1** from the **[BUC1]**, a subtraction of the **BInst2** from the **[BUC2]**, a subtraction of the **BInst3** from the **[BUC3]**, a subtraction of the **BInst4** from the **[BUC4]**, a subtraction of the **BInstS** from the **[BUC5]**, a subtraction of the **BInst6** from the **[BUC6]**, a subtraction of the **BInst7** from the **[BUC7]**, a subtraction of the **BInst8** from the **[BUC8]**, and the [PS]; wherein the method is executed in following sequence: (1) the Step A0, the Step A, and the Step B, or (2) the Step A, the Step A0, and the Step B.

In an embodiment, wherein in the Step A0, measuring the **BInst** by the fifth MFS comprises following steps of: Step A51: rotating the SASA around a first axis of the fifth MFS by at least 180 degrees, in the meantime, measuring magnetic field by the fifth MFS, wherein a fifth-magnetic-field-sensor-first-axis measurement sequence **[BZ5]** (hereinafter, referred to as "**[BZ5]**") is measured by the fifth MFS; Step A52: rotating the SASA around a second axis of the fifth MFS by at least 180 degrees, in the meantime, measuring magnetic field by the fifth MFS, wherein a fifth-magnetic-field-sensor-second-axis measurement sequence **[BX5]** (hereinafter, referred to as "**[BX5]**") is measured by the fifth MFS, wherein the first axis of the fifth MFS and the second axis of the fifth MFS are orthogonal; and Step A53: calculating the **BInstS** from the **[BZ5]** and the **[BX5]**; wherein measuring the **BInst** by the sixth MFS comprises following steps of: Step A61: rotating the SASA around a first axis of the sixth MFS by at least 180 degrees, in the meantime, measuring magnetic field by the sixth MFS, wherein a sixth-magnetic-field-sensor-first-axis measurement sequence **[BZ6]** (hereinafter, referred to as "**[BZ6]**") is measured by the sixth MFS; Step A62: rotating the SASA around a second axis of the sixth MFS by at least 180 degrees, in the meantime, measuring magnetic field by the sixth MFS, wherein a sixth-magnetic-field-sensor-second-axis measurement sequence **[BX6]** (hereinafter, referred to as "**[BX6]**") is measured by the sixth MFS, wherein the first axis of the sixth MFS and the second axis of the sixth MFS are orthogonal; and Step A63: calculating the **BInst6** from the **[BZ6]** and the **[BX6]**; wherein measuring the **BInst** by the seventh MFS comprises following steps of: Step A71: rotating the SASA around a first axis of the seventh MFS by at least 180 degrees, in the meantime, measuring magnetic field by the seventh MFS, wherein a seventh-magnetic-field-sensor-first-axis measurement sequence **[BZ7]** (hereinafter, referred to as "**[BZ7]**") is measured by the seventh MFS; Step A72: rotating the SASA around a second axis of the seventh MFS by at least 180 degrees, in the meantime, measuring magnetic field by the seventh MFS, wherein a seventh-magnetic-field-sensor-second-axis measurement sequence **[BX7]** (hereinafter, referred to as "**[BX7]**") is measured by the seventh MFS, wherein the first axis of the seventh MFS and the second axis of the seventh MFS are orthogonal; and Step A73: calculating the **BInst7** from the **[BZ7]** and the **[BX7]**; wherein measuring the **BInst** by the eighth MFS comprises following steps of: Step A81: rotating the SASA around a first axis of the eighth MFS by at least 180 degrees, in the meantime, measuring magnetic field by the eighth MFS, wherein an eighth-magnetic-field-sensor-first-axis measurement sequence **[BZ8]** (hereinafter, referred to as "**[BZ8]**") is measured by the eighth MFS; Step A82: rotating the SASA around a second axis of the eighth MFS by at least 180 degrees, in the meantime, measuring magnetic field by the eighth MFS, wherein an eighth-magnetic-field-sensor-second-axis measurement sequence **[BX8]** (hereinafter, referred to as "**[BX8]**") is measured by the eighth MFS, wherein the first axis of the eighth MFS and the second axis of the eighth MFS are orthogonal; and Step A83: calculating the **BInst8** from the **[BZ8]** and the **[BX8]**.

In an embodiment, wherein the first MFS, the second MFS, the third MFS, the fourth MFS, the fifth MFS, the sixth MFS, the seventh MFS, and the eighth MFS are located respectively at eight vertices of a parallelepiped, located respectively at eight vertices of a cuboid, or located respectively at eight vertices of a regular hexahedron.

In an embodiment, wherein in the Step A0, measuring the **BInst** by the first MFS comprises following steps of: Step A11: rotating the SASA around a first axis of the first MFS by at least 180 degrees, in the meantime, measuring magnetic field by the first MFS, wherein a first-magnetic-field-sensor-first-axis measurement sequence **[BZ1]** (hereinafter, referred to as "**[BZ1]**") is measured by the first MFS; Step A12: rotating the SASA around a second axis of the first MFS by at least 180 degrees, in the meantime, measuring magnetic field by the first MFS, wherein a first-magnetic-field-sensor-second-axis measurement sequence **[BX1]** (hereinafter, referred to as "**[BX1]**") is measured by the first MFS, wherein the first axis of the first MFS and the second axis of the first MFS are orthogonal; and Step A13: calculating the **BInst1** from the **[BZ1]** and the **[BX1]**; wherein measuring the **BInst** by the second MFS comprises following steps of: Step A21: rotating the SASA around a first axis of the second MFS by at least 180 degrees, in the meantime, measuring magnetic field by the second MFS, wherein a second-magnetic-field-sensor-first-axis measurement sequence **[BZ2]** (hereinafter, referred to as "**[BZ2]**") is measured by the second MFS; Step A22: rotating the SASA around a second axis of the second MFS by at least 180 degrees, in the meantime, measuring magnetic field by the second MFS, wherein a second-magnetic-field-sensor-second-axis measurement sequence **[BX2]** (hereinafter, referred to as "**[BX2]**") is measured by the second MFS, wherein the first axis of the second MFS and the second axis of the second MFS are orthogonal; and Step A23: calculating the **BInst2** from the **[BZ2]** and the **[BX2]**; wherein measuring the **BInst** by the third MFS comprises following steps of: Step A31: rotating the SASA around a first axis of the third MFS by at least 180 degrees, in the meantime, measuring magnetic field by the third MFS, wherein a third-magnetic-field-sensor-first-axis measurement sequence **[BZ3]** (hereinafter, referred to as "**[BZ3]**") is measured by the third MFS; Step A32: rotating the SASA around a second axis of the third MFS by at least 180 degrees, in the meantime, measuring magnetic field by the third MFS, wherein a third-magnetic-field-sensor-second-axis measurement sequence **[BX3]** (hereinafter, referred to as "**[BX3]**") is measured by the third MFS, wherein the first axis of the third MFS and the second axis of the third MFS are orthogonal; and Step A33: calculating the **BInst3** from the **[BZ3]** and the **[BX3]**; wherein measuring the **BInst** by the fourth MFS comprises following steps of: Step A41: rotating the SASA around a first axis of the fourth MFS by at least 180 degrees, in the meantime, measuring magnetic field by the fourth MFS, wherein a fourth-magnetic-field-sensor-first-axis measurement sequence **[BZ4]** (hereinafter, referred to as "**[BZ4]**") is measured by the fourth MFS; Step A42: rotating the SASA around a second axis of the fourth MFS by at least 180 degrees, in the meantime, measuring magnetic field by the fourth MFS, wherein a fourth-magnetic-field-sensor-second-axis measurement sequence **[BX4]** (hereinafter, referred to as "**[BX4]**") is measured by the fourth MFS, wherein the first axis of the fourth MFS and the second axis of the fourth MFS are orthogonal; and Step A43: calculating the **BInst4** from the **[BZ4]** and the **[BX4]**.

In an embodiment, wherein the first MFS, the second MFS, the third MFS, and the fourth MFS are located respectively at four vertices of an equilateral-triangle-based pyramid or located respectively at four vertices of a regular tetrahedron.

In an embodiment, wherein the magnetic field variation distribution **BVarD** is a magnetic field gradient-vector distribution, a magnetic field gradient-vector-magnitude distribution, a magnetic field gradient-vector-horizontal-component distribution, or a magnetic field gradient-vector-horizontal-component-magnitude distribution.

The present invention further provides a scanning artificial structure apparatus (SASA), which comprises a magnetic field sensing portion. The magnetic field sensing portion comprises a first MFS, a second MFS, a third MFS, and a fourth MFS, wherein the first MFS, the second MFS, the third MFS, and the fourth MFS are non-coplanar configured. The SASA is for performing the method for scanning artificial structure described the above.

In an embodiment, wherein the magnetic field sensing portion further comprises a fifth MFS, a sixth MFS, a seventh MFS, and an eighth MFS.

In an embodiment, wherein the first MFS, the second MFS, the third MFS, the fourth MFS, the fifth MFS, the sixth MFS, the seventh MFS, and the eighth MFS are located respectively at eight vertices of a parallelepiped, located respectively at eight vertices of a cuboid, or located respectively at eight vertices of a regular hexahedron.

In an embodiment, wherein the first MFS, the second MFS, the third MFS, and the fourth MFS are located respectively at four vertices of an equilateral-triangle-based pyramid or located respectively at four vertices of a regular tetrahedron.

In an embodiment, the SASA further comprises a positioning portion.

In an embodiment, wherein the positioning portion is one selected from the group consisting of: a ranging wheel, a distance measuring equipment, a rule, a measuring tape, a laser positioning device, an ultrasonic positioning device, a radar wave positioning device, a GPS positioning device, and an image positioning device.

For further understanding the characteristics and effects of the present invention, some preferred embodiments referred to drawings are in detail described as follows.

**Brief description of drawings**

Figure 1 is a schematic perspective view showing an embodiment of a scanning artificial structure apparatus of the present invention.

Figure 2 is a schematic view showing the scanning path and the magnetic field variation distribution within the to-be-tested area and the corresponding artificial structure distribution.

Figure 3 is a schematic perspective view showing another embodiment of a scanning artificial structure apparatus of the present invention.

Figure 4 is a schematic view showing three axes of each of the magnetic field sensors of the magnetic field sensing portion of the embodiment of the scanning artificial structure apparatus of Figure 3.

Figure 5 is a schematic view showing the vector **V** rotates around the **K** axis by an angle θ.

Figure 6 is a schematic view showing the embodiment of the scanning artificial structure apparatus of Figure 3 rotates around the **Z1** axis of the first magnetic field sensor.

Figure 7A is a graph showing the **X1** axis component and the **Y1** axis component of the magnetic field measured by the first magnetic field sensor during the embodiment of the scanning artificial structure apparatus of Figure 3 rotating around the **Z1** axis of the first magnetic field sensor.

Figure 7B is a graph showing the **Z1** axis component of the magnetic field measured by the first magnetic field sensor during the embodiment of the scanning artificial structure apparatus of Figure 3 rotating around the **Z1** axis of the first magnetic field sensor.

Figure 8 is a schematic view showing the embodiment of the scanning artificial structure apparatus of Figure 3 rotates around the **X1** axis of the first magnetic field sensor.

Figure 9 is a schematic perspective view showing an embodiment of a scanning artificial structure apparatus of the present invention.

Figure 10 is a schematic perspective view showing another embodiment of a scanning artificial structure apparatus of the present invention.

Figure 11 is a schematic view showing three axes of each of the magnetic field sensors of the magnetic field sensing portion of the embodiment of the scanning artificial structure apparatus of Figure 10.

Figure 12 is a schematic view showing the conventional technology measuring the magnetic field.

**Detailed Descriptions of Preferred Embodiments**

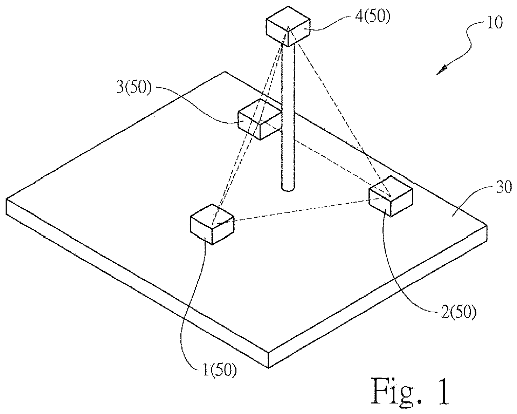

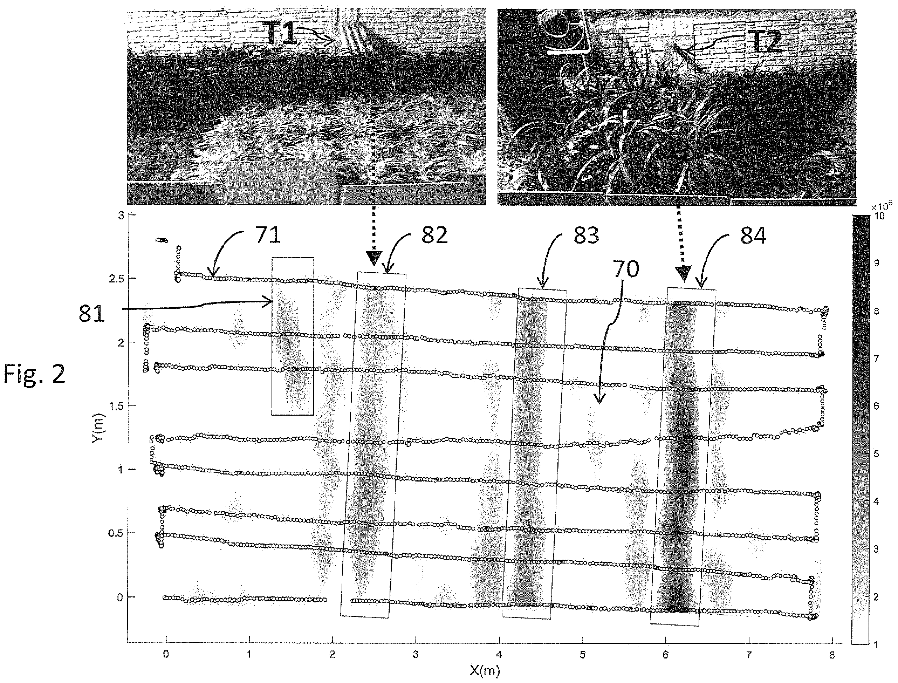

Please refer to Figure 1, which is a schematic perspective view showing an embodiment of a scanning artificial structure apparatus of the present invention. The present invention provides a scanning artificial structure apparatus (SASA) 10 comprising a carrier portion 30 and a magnetic field sensing portion 50. The the magnetic field sensing portion 50 are configured on the carrier portion 30. The magnetic field sensing portion 50 is used for measuring the magnetic field. The magnetic field sensing portion 50 comprises a first magnetic field sensor (first MFS) 1, a second magnetic field sensor (second MFS) 2, a third magnetic field sensor (third MFS) 3, and a fourth magnetic field sensor (fourth MFS) 4, wherein the first MFS 1, the second MFS 2, the third MFS 3, and the fourth MFS 4 are non-coplanar configured. In current embodiment, the carrier portion 30 of the SASA is made of materials that avoid the generation of induced magnetic fields, such as plastic, or some non-metal materials. Since an artificial structure will generate an artificial structure magnetic field **BArtificial** (vector field) due to induction. Especially when the artificial structure includes an electrically conductive material, it is more likely to generate the **BArtificial** due to induction. When scanning the artificial structure by the SASA 10, for any of the magnetic field sensors, the measured magnetic field measurement (vector) is the sum of the **BArtificial** and the **BEarth** of the measured position. The source of the **BEarth** is very far away from the first MFS 1, the second MFS 2, the third MFS 3, and the fourth MFS 4 of the SASA 10. If consider the **BEarth** is a magnetic dipole, one of the poles is located near the geographic North Pole, while the other is located near the geographic South Pole. Relatively speaking, the source of the **BArtificial** is relatively much closer to the first MFS 1, the second MFS 2, the third MFS 3, and the fourth MFS 4 of the SASA 10. Since the first MFS 1, the second MFS 2, the third MFS 3, and the fourth MFS 4 are non-coplanar configured, using different MFS to measure magnetic field. Therefore, the components of the **BEarth** of the magnetic field measurements measured by different magnetic field sensors (including the components of the **BEarth** and the components of the **BArtificial**) are almost the same, while the components of the **BArtificial** of the magnetic field measurements may be different. Please also refer to Figure 2, which is a schematic view showing the scanning path and the magnetic field variation distribution within the to-be-tested area and the corresponding artificial structure distribution. The present invention provides a method for scanning artificial structure, which comprises following steps of: Step A: moving the SASA 10 along a scanning path 71 within a to-be-tested area 70, in the meantime, measuring magnetic field by the first MFS 1, the second MFS 2, the third MFS 3, and the fourth MFS 4 respectively, and recording a position sequence [PS], wherein a first magnetic field measurement sequence **[BUC1]** is measured by the first MFS 1, a second magnetic field measurement sequence **[BUC2]** is measured by the second MFS 2, a third magnetic field measurement sequence **[BUC3]** is measured by the third MFS 3, and a fourth magnetic field measurement sequence **[BUC4]** is measured by the fourth MFS 4; and Step B: calculating a magnetic field variation distribution **BVarD** from the **[BUC1],** the **[BUC2],** the **[BUC3],** the **[BUC4],** and the [PS]. Since the **BEarth** will not significantly change within a short time period in a local area, and the source of the **BEarth** is very far away from the first MFS 1, the second MFS 2, the third MFS 3, and the fourth MFS 4, hence, the components of the **BEarth** measured by the first MFS 1, the second MFS 2, the third MFS 3, and the fourth MFS 4 are almost no difference. Since the source of the **BArtificial** is relatively much closer to the first MFS 1, the second MFS 2, the third MFS 3, and the fourth MFS 4, and the first MFS 1, the second MFS 2, the third MFS 3, and the fourth MFS 4 are non-coplanar configured, hence, at least two of the components of the **BArtificial** measured by the first MFS 1, the second MFS 2, the third MFS 3, and the fourth MFS 4 are difference regardless of the direction of the artificial structure magnetic field **BArtificial**. Therefore, the components of the **BArtificial** and also the components of the **BEarth** can be calculated from the **[BUC1],** the **[BUC2],** the **[BUC3],** and the **[BUC4]** measured by the first MFS 1, the second MFS 2, the third MFS 3, and the fourth MFS 4. In current embodiments, the magnetic field variation distribution **BVarD** is a magnetic field gradient-vector-magnitude distribution (scalar) which combines the [PS] and a magnetic field gradient-vector-magnitude sequence (scalar sequence) calculated from the **[BUC1],** the **[BUC2]**, the **[BUC3],** and the **[BUC4]**. The magnetic field variation distribution **BVarD** is corresponding to the **BArtificial** generated by the artificial structure due to induction. Hence, the magnetic field variation distribution **BVarD** is corresponding to an artificial structure distribution. Since the first magnetic field sensor 1, the second magnetic field sensor 2, the third magnetic field sensor 3, and the fourth magnetic field sensor 4 are non-coplanar configured in present invention, the magnetic field gradient along any direction can be calculated (if the first magnetic field sensor 1, the second magnetic field sensor 2, the third magnetic field sensor 3, and the fourth magnetic field sensor 4 are configured on a coplanar, then the magnetic field gradient along the direction of a normal of the coplanar cannot be calculated). In Figure 2, the magnetic field variation distribution **BVarD** is demonstrated in grayscale color, whererin the darker the grayscale color, the greater the magnetic field variation. The four regions with larger the magnetic field variation are 81, 82, 83 and 84. This shows that there should be at least one corresponding artificial structure distribution under the regions 81, 82, 83 and 84 within the to-be-tested area 70. The photo on the left side above the Figure 2 has metal water pipes T1, while the photo on the right side above the Figure 2 has metal water pipes T2, wherein the metal water pipes T1 extend below the area corresponding to 82 within the to-be-tested area 70, wherein the metal water pipes T2 extend below the area corresponding to 84 within the to-be-tested area 70. Hence, the method for scanning artificial structure of the present invention can indeed scan the corresponding artificial structure distribution under the to-be-tested area 70, so as to facilitate the avoidance of these artificial structures during construction mining.

In some embodiments, the SASA 10 can be selected to be moved by hand. In some embodiments, recording the position sequence [PS] of the measured positions can be achieved by a simple distance measuring tool, such as a ranging wheel, a distance measuring equipment, a rule, a measuring tape, or a laser positioning device, etc. In some embodiments, the SASA 10 can be fixed on the handle of the ranging wheel so that recording the [PS] of the measured position while measuring magnetic field can be achieved. In some embodiments, the positions where magnetic field will be measured on the scanning path 71 within the to-be-tested area 70 can be planned in advanced and the position sequence [PS] can be obtained by measuring the distance between the adjacent positions in advance; and then the SASA 10 is moved to these positions to measure magnetic field. In some embodiments, wheels can be mounted under the carrier portion 30 to facilitate stable movement of the SASA 10, wherein the wheels are made of the materials that avoids the generation of the induced magnetic field. In some embodiments, the magnetic field variation distribution **BVarD** is a magnetic field gradient-vector distribution (vector) which combines the [PS] and a magnetic field gradient-vector sequence (vector sequence) calculated from the **[BUC1],** the **[BUC2],** the **[BUC3]**, and the **[BUC4].** In some embodiments, the magnetic field variation distribution **BVarD** is a magnetic field gradient-vector-horizontal-component distribution (vector) which combines the [PS] and a magnetic field gradient-vector-horizontal-component sequence (vector sequence) calculated from the **[BUC1],** the **[BUC2],** the **[BUC3],** and the **[BUC4]**. In some embodiments, the magnetic field variation distribution **BVarD** is a magnetic field gradient-vector-horizontal-component-magnitude distribution (scalar) which combines the [PS] and a magnetic field gradient-vector-horizontal-component-magnitude sequence (scalar sequence) calculated from the **[BUC1],** the **[BUC2],** the **[BUC3],** and the **[BUC4]**. To calculated the magnetic field variation distribution **BVarD** from the **[BUC1],** the **[BUC2],** the **[BUC3],** the **[BUC4]** and the [PS] of the measured positions are not limited to the above method. It is easy to calculate the magnetic field variation distribution **BVarD** when the **[BUC1],** the **[BUC2],** the **[BUC3],** the **[BUC4]** and the [PS] of the measured positions are known.

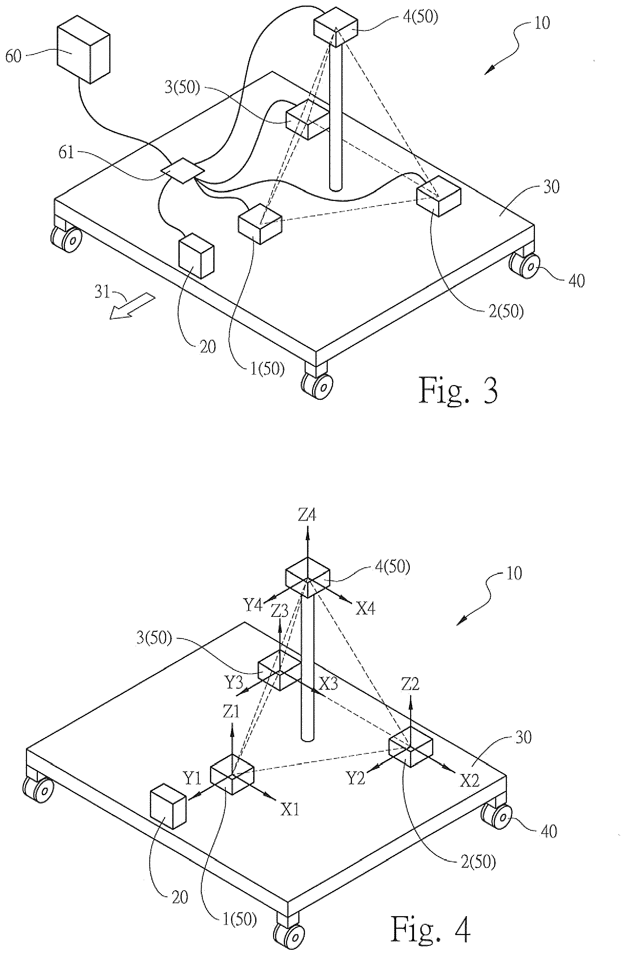

Please refer to Figure 3, which is a schematic perspective view showing another embodiment of a scanning artificial structure apparatus of the present invention. The main structure of the embodiment of Figure 3 is basically the same as the structure of the embodiment of Figure 1, except that it further comprises a connecting portion 61, a moving portion 40 and a positioning portion 20. The positioning portion 20 and the connecting portion 61 are configured on the carrier portion 30. The positioning portion 20 is used for positioning for recording the position sequence [PS]. A data processing portion 60 is connected to the connecting portion 61 by wire. The data processing portion 60 is connected to the first MFS 1, the second MFS 2, the third MFS 3, and the fourth MFS 4 by wire respectively via the connecting portion 61. The data processing portion 60 is used for recording the magnetic field data measured by the first MFS 1, the second MFS 2, the third MFS 3, and the fourth MFS 4 and the position data from the positioning portion 20 (or used for recording the data and processing the data). In current embodiment, the data processing portion 60 is configured outside the SASA 10. The SASA 10 has a front 31. The moving portion 40 is configured below the carrier portion 30. The moving portion 40 is used for moving the SASA 10. The direction of the moving portion 40 can be turned so that the direction of the front 31 of the SASA 10 can be turned. Please also refer to Figure 4, which is a schematic view showing three axes of each of the magnetic field sensors of the magnetic field sensing portion of the embodiment of the scanning artificial structure apparatus of Figure 3. Each of the magnetic field sensors of the magnetic field sensing portion 50 has three axes. For example, the first MFS 1 has a **X1** axis, a **Y1** axis, and a **Z1** axis; the second MFS 2 has a **X2** axis, a **Y2** axis, and a **Z2** axis; the third MFS 3 has a **X3** axis, a **Y3** axis, and a **Z3** axis; the fourth MFS 4 has a **X4** axis, a **Y4** axis, and a **Z4** axis. Usually the three axes of each of the magnetic field sensors of the magnetic field sensing portion 50 are marked on the magnetic field sensor before the magnetic field sensor is shipped for the convenience of users. In current embodiment, the moving portion 40 is the steerable wheels with motor power. The operation of the motor may generate a magnetic field. Hence, the SASA 10 of the present invention may generate an instrument magnetic field **BInst** (vector field). When scanning the artificial structure by the SASA 10, for any of the magnetic field sensors, the measured magnetic field measurement (vector) is the sum of the **BEarth,** the **BArtificial,** and the **BInst** of the measured position. The **BInst** can cause interference to each of the magnetic field sensors of the magnetic field sensing portion 50. Therefore, the interference of the **BInst** to each of the magnetic field sensors of the magnetic field sensing portion 50 must be removed. Since the **BInst** is generated by the SASA 10, when the direction of the front 31 of the SASA 10 is changed, the direction of the **BInst** is changed. Since the first MFS 1, the second MFS 2, the third MFS 3, and the fourth MFS 4 are configured on the carrier portion 30 of the SASA 10, when the direction of the front 31 of the SASA 10 is changed, the directions of the **X1** axis, the **Y1** axis, and the **Z1** axis of the first MFS 1, the directions of the **X2** axis, the **Y2** axis, and the **Z2** axis of the second MFS 2, the directions of the **X3** axis, the **Y3** axis, and the **Z3** axis of the third MFS 3, and the directions of the **X4** axis, the **Y4** axis, and the **Z4** axis of the fourth MFS 4 are changed. Hence, no matter how the direction of the front 31 of the SASA 10 is changed, for any of the magnetic field sensors of the magnetic field sensing portion 50, the **BInst** is always a constant vector (the magnitude and the direction are unchanged). However, for different magnetic field sensors of the magnetic field sensing portion 50, the measured values (vector) of the **BInst** (vector field) are different. Let the first MFS 1, the second MFS 2, the third MFS 3 and the fourth MFS 4 to measure the **BInst,** the measured values are a first instrument magnetic field measurement **BInst1** (vector), a second instrument magnetic field measurement **BInst2** (vector), a third instrument magnetic field measurement **BInst3** (vector), and a fourth instrument magnetic field measurement **BInst4** (vector), respectively. The **BInst1,** the **BInst2,** the **BInst3,** and the **BInst4** are four different vectors. However, the **BEarth** will not change when the direction of the front 31 of the SASA 10 is changed. That is that, for example, when the direction of the front 31 of the SASA 10 is changed from the East direction to the North direction (that is turning 90 degrees counterclockwise), the direction of the **BInst** is also turning 90 degrees counterclockwise; while the **BEarth** will not change.

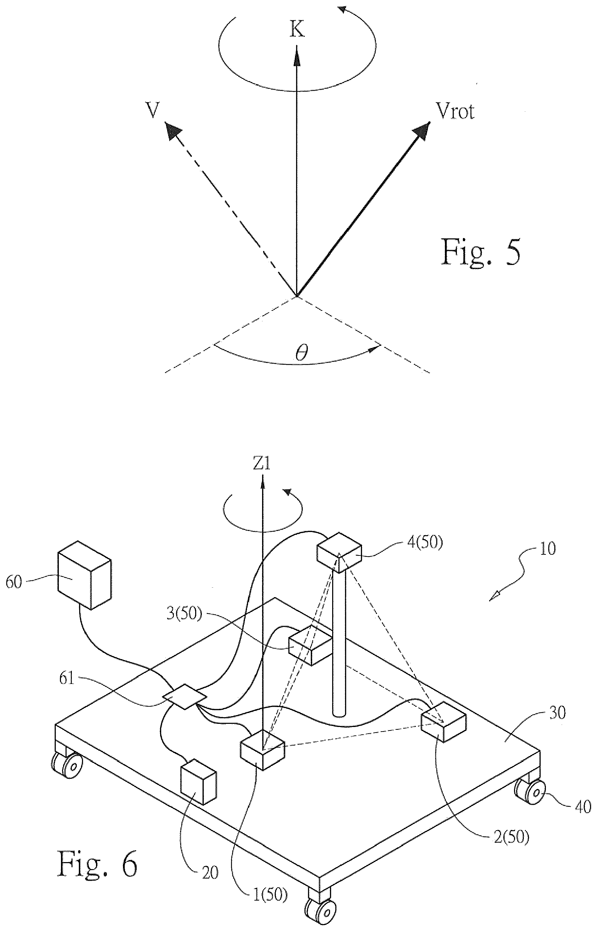

Take advantage of this feature, if let the SASA 10 rotate around the **Z1** axis of the first MFS 1 by an angle θ, from the perspective view of the first MFS 1, the **BEarth** is rotating around the **Z1** axis of the first MFS 1; while the **BInst** is a constant vector (will not rotate around the **Z1** axis of the first MFS 1). Please refer to Figure 5, which is a schematic view showing the vector **V** rotates around the **K** axis by an angle θ. For the relation between the vector **V** and the vector **V**$_{rot}$ which is the vector **V** rotated around the **K** axis by the angle θ, please refer to Rodrigues' rotation equation:

$$\mathbf{V}_{rot} = \mathbf{V}\cos\theta + (\mathbf{K} \times \mathbf{V})\sin\theta + \mathbf{K}(\mathbf{K} \cdot \mathbf{V})(1 - \cos\theta) \dots\dots\dots\dots\dots\dots \text{(equation 1)}$$

(wherein the vector **V** rotated around the **K** axis by the angle θ becomes the vector **V**$_{rot}$;
× is a cross product; · is a dot product)

Please also refer to Figure 6, which is a schematic view showing the embodiment of the scanning artificial structure apparatus of Figure 3 rotates around the **Z1** axis of the first magnetic field sensor. As shown in Figure 6, when the SASA 10 rotates around the **Z1** axis (the first axis) of the first MFS 1 by an angle θ, let the first MFS 1 to measure the magnetic field, the measured value is as follows:

$$\mathbf{BZ1}_{total\_\theta} = \mathbf{BEarth}_{rotate\_Z1\_\theta} + \mathbf{BInst1}$$
$$= (\mathbf{BEarth}\cos\theta + (\mathbf{Z1} \times \mathbf{BEarth})\sin\theta + \mathbf{Z1}(\mathbf{Z1} \cdot \mathbf{BEarth})(1 - \cos\theta))$$
$$+ \mathbf{BInst1} \ldots\ldots\ldots\ldots\ldots\ldots\ldots\ldots\ldots\ldots\ldots\ldots\ldots\ldots (\text{equation } 2)$$

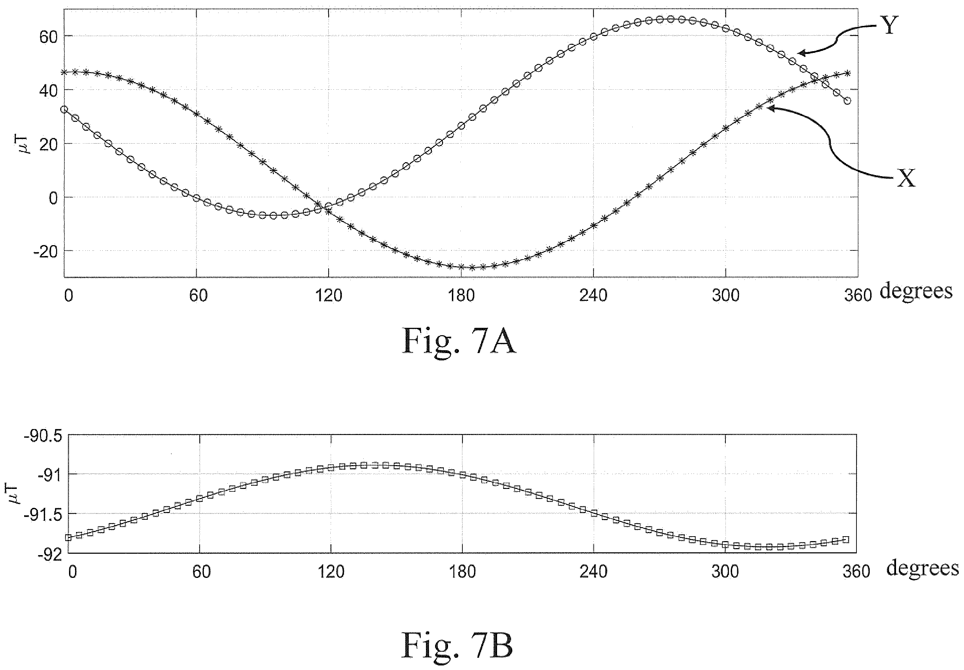

In equation 2, a first-magnetic-field-sensor-first-axis measurement $\mathbf{BZ1}_{total\_\theta}$ is the total magnetic field measurement (vector) measured by the first MFS 1 when the SASA 10 rotated around the **Z1** axis of the first MFS 1 by an angle θ. The first-magnetic-field-sensor-first-axis measurement $\mathbf{BZ1}_{total\_\theta}$ is the sum of a component of the **BEarth** and a component of the **BInst.** The component of the **BEarth** is $\mathbf{BEarth}_{rotate\_Z1\_\theta}$ (vector) which is measured by the first MFS 1 when the SASA 10 rotated around the **Z1** axis of the first MFS 1 by the angle θ. The component of the **BInst** is the **BInst1** which is measured by the first MFS 1 when the SASA 10 rotated around the **Z1** axis of the first MFS 1 by the angle θ. In fact, no matter how much degree the SASA 10 rotated around the **Z1** axis of the first MFS 1, the component of the **BInst** measured by the first MFS 1 is always the **BInst1.** Take advantage of the above feature, the method for scanning artificial structure of the present invention further comprises a following step of: Step A0: measuring the **BInst** generated by the SASA 10 by the first MFS 1, the second MFS 2, the third MFS 3, and the fourth MFS 4, respectively, wherein the **BInst1,** the **BInst2,** the **BInst3,** and the **BInst4** are measured by the first MFS 1, the second MFS 2, the third MFS 3, and the fourth MFS 4. In the Step B, the magnetic field variation distribution **BVarD** is calculated from a subtraction of the **BInst1** from the **[BUC1],** a subtraction of the **BInst2** from the **[BUC2],** a subtraction of the **BInst3** from the **[BUC3],** a subtraction of the **BInst4** from the **[BUC4]**, and the [PS]. Thereby the interference to the first MFS 1, the second MFS 2, the third MFS 3, and the fourth MFS 4 caused by the **BInst** can be removed, respectively. The method for scanning artificial structure of the present invention is executed in following sequence: (1) the Step A0, the Step A, and the Step B, or (2) the Step A, the Step A0, and the Step B. In the Step A0, to use the first MFS 1 to measure the **BInst** generated by the SASA 10 comprises following steps of: Step A11, Step A12, and Step A13. The Step A11: (as shown in Figure 6) rotating the SASA 10 around the first axis of the first MFS 1 by at least 180 degrees (in current embodiment, the first axis of the first MFS 1 may be the **Z1** axis or an axis almost coincident with the **Z1** axis), in the meantime, measuring magnetic field by the first MFS 1, wherein a first-magnetic-field-sensor-first-axis measurement sequence **[BZ1]** (sequence of vectors) is measured by the first MFS 1. During the SASA 10 is rotating around the first axis of the first MFS 1, the first-magnetic-field-sensor-first-axis measurement $\mathbf{BZ1}_{total\_\theta}$ is measured by the first MFS 1. At different angle θ, the first-magnetic-field-sensor-first-axis measurement $\mathbf{BZ1}_{total\_\theta}$ measured by the first MFS 1 is different. The **[BZ1]** is a sequence composed of the first-magnetic-field-sensor-first-axis measurements $\mathbf{BZ1}_{total\_\theta}$ (with different angle θ). Please also refer to Figures 7A and 7B, which are the graphs showing the **X1** axis component, the **Y1** axis component and the **Z1** axis component of the magnetic field measured by the first magnetic field sensor during the embodiment of the scanning artificial structure apparatus of Figure 3 rotating around the **Z1** axis of the first magnetic field sensor. In the embodiment of Figures 7A and 7B, the SASA 10 rotates around the first axis (the **Z1** axis) of the first MFS 1 by 360 degrees. Figure 7A shows the **X1** axis component and the **Y1** axis component of each of the first-magnetic-field-sensor-first-axis measurements $\mathbf{BZ1}_{total\_\theta}$ in the **[BZ1]**. Figure 7B shows the **Z1** axis component of each of the first-magnetic-field-sensor-first-axis measurements $\mathbf{BZ1}_{total\_\theta}$ in the **[BZ1]**. Since the actual rotation is around an axis almost coincident with the **Z1** axis, there exists small variation in the elements of the **[BZ1]** in Figure 7B. The equation 2 above may be derived as equation 3 below:

$$\mathbf{BZ1}_{total\_\theta}$$
$$= (\mathbf{BEarth}\cos\theta + (\mathbf{Z1} \times \mathbf{BEarth})\sin\theta - \mathbf{Z1}(\mathbf{Z1} \cdot \mathbf{BEarth})\cos\theta)$$
$$+ (\mathbf{Z1}(\mathbf{Z1} \cdot \mathbf{BEarth}) + \mathbf{BInst1}) \ldots\ldots\ldots\ldots\ldots\ldots (\text{equation } 3)$$

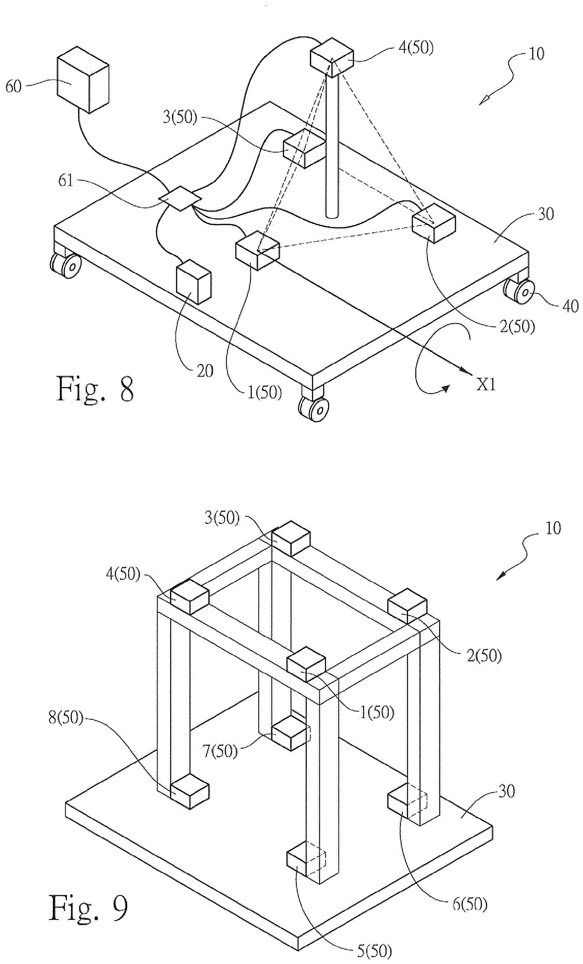

In equation 3, (**BEarth** cos θ + (**Z1** × **BEarth**) sin θ _ **Z1**(**Z1** · **BEarth**) cos θ) is the component related to the angle θ, while (**Z1**(**Z1** · **BEarth**) + **BInst1**) is the component independent of the angle θ. Without knowing the **BEarth,** the **BInst1** cannot be calculated from Step A11. Hence, Step 12 is also required. The Step 12: (as shown in Figure 8) rotating the SASA 10 around the second axis of the first MFS 1 by at least 180 degrees (in current embodiment, the second axis of the first MFS 1 may be the **X1** axis or an axis almost coincident with the **X1** axis), in the meantime, measuring magnetic field by the first MFS 1, wherein a first-magnetic-field-sensor-second-axis measurement sequence **[BX1]** (sequence of vectors) is measured by the first MFS 1, wherein the second axis of the first MFS 1 is orthogonal to the first axis of the first MFS 1. During the SASA 10 is rotating around the second axis of the first MFS 1, the first-magnetic-field-sensor-second-axis measurement $BX1_{total\_\theta}$ is measured by the first MFS 1. At different angle $\theta$, the first-magnetic-field-sensor-second-axis measurement $BX1_{total\_\theta}$ measured by the first MFS 1 is different. The **[BX1]** is a sequence composed of the first-magnetic-field-sensor-second-axis measurements $BX1_{total\_\theta}$ (with different angle $\theta$). The first-magnetic-field-sensor-second-axis measurement $BX1_{total\_\theta}$ may be derived as equation 4 below:

$$BX1_{total\_\theta} = BEarth_{rotate\_X1\_\theta} + BInst1$$

$$= (BEarth \cos\theta + (X1 \times BEarth)\sin\theta + X1(X1 \cdot BEarth)(1 - \cos\theta)) + BInst1$$

$$= (BEarth \cos\theta + (X1 \times BEarth)\sin\theta - X1(X1 \cdot BEarth)\cos\theta)$$

$$+ (X1(X1 \cdot BEarth) + BInst1) \dots\dots\dots\dots\dots\dots\dots\dots (equation\ 4)$$

In equation 4, a first-magnetic-field-sensor-second-axis measurement $BX1_{total\_\theta}$ is the total magnetic field measurement (vector) measured by the first MFS 1 when the SASA 10 rotated around the **X1** axis of the first MFS 1 by an angle $\theta$. The first-magnetic-field-sensor-second-axis measurement $BX1_{total\_\theta}$ is the sum of a component of the **BEarth** and a component of the **BInst**. The component of the **BEarth** is $BEarth_{rotate\_X1\_\theta}$ (vector) which is measured by the first MFS 1 when the SASA 10 rotated around the **X1** axis of the first MFS 1 by the angle $\theta$. The component of the **BInst** is the **BInst1** which is measured by the first MFS 1 when the SASA 10 rotated around the **X1** axis of the first MFS 1 by the angle $\theta$. In fact, no matter how much degree the SASA 10 rotated around the **Z1** axis of the first MFS 1, the component of the **BInst** measured by the first MFS 1 is always the **BInst1.** The Step A13: calculating the **BInst1** from the **[BZ1]** and the **[BX1].**

Similarly, in the Step A0, to use the second MFS 2 to measure the **BInst** generated by the SASA 10 comprises following steps of: Step A21: rotating the SASA 10 around the first axis (the **Z2** axis) of the second MFS 2 by at least 180 degrees, in the meantime, measuring magnetic field by the second MFS 2, wherein a second-magnetic-field-sensor-first-axis measurement sequence **[BZ2]** (sequence of vectors) is measured by the second MFS 2; Step A22: rotating the SASA 10 around the second axis (the **X2** axis) of the second MFS 2 by at least 180 degrees, in the meantime, measuring magnetic field by the second MFS 2, wherein a second-magnetic-field-sensor-second-axis measurement sequence **[BX2]** (sequence of vectors) is measured by the second MFS 2, wherein the second axis of the second MFS 2 is orthogonal to the first axis of the second MFS 2; and Step A23: calculating the **BInst2** from the **[BZ2]** and the **[BX2].** In the Step A0, to use the third MFS 3 to measure the **BInst** generated by the SASA 10 comprises following steps of: Step A31: rotating the SASA 10 around the first axis (the **Z3** axis) of the third MFS 3 by at least 180 degrees, in the meantime, measuring magnetic field by the third MFS 3, wherein a third-magnetic-field-sensor-first-axis measurement sequence **[BZ3]** (sequence of vectors) is measured by the third MFS 3; Step A32: rotating the SASA 10 around the second axis (the **X3** axis) of the third MFS 3 by at least 180 degrees, in the meantime, measuring magnetic field by the third MFS 3, wherein a third-magnetic-field-sensor-second-axis measurement sequence **[BX3]** (sequence of vectors) is measured by the third MFS 3, wherein the second axis of the third MFS 3 is orthogonal to the first axis of the third MFS 3; and Step A33: calculating the **BInst3** from the **[BZ3]** and the **[BX3].** In the Step A0, to use the fourth MFS 4 to measure the **BInst** generated by the SASA 10 comprises following steps of: Step A41: rotating the SASA 10 around the first axis (the **Z4** axis) of the fourth MFS 4 by at least 180 degrees, in the meantime, measuring magnetic field by the fourth MFS 4, wherein a fourth-magnetic-field-sensor-first-axis measurement sequence **[BZ4]** (sequence of vectors) is measured by the fourth MFS 4; Step A42: rotating the SASA 10 around the second axis (the **X4** axis) of the fourth MFS 4 by at least 180 degrees, in the meantime, measuring magnetic field by the fourth MFS 4, wherein a fourth-magnetic-field-sensor-second-axis measurement sequence **[BX4]** (sequence of vectors) is measured by the fourth MFS 4, wherein the second axis of the fourth MFS 4 is orthogonal to the first axis of the fourth MFS 4; and Step A33: calculating the **BInst4** from the **[BZ4]** and the **[BX4]**.

In some embodiments, the positioning portion 20 is connected to the data processing portion 60 by wireless connection. In some embodiments, the first MFS 1, the second MFS 2, the third MFS 3, and the fourth MFS 4 are connected to the data processing portion 60 respectively by wireless connection. In some embodiments, the data processing portion 60 is not configured on the carrier portion 30 of the SASA 10. In some embodiments, the moving portion 40 comprises wheels. In some embodiments, the positioning portion 20 is one selected from the group consisting of: a ranging wheel, a distance measuring equipment, a rule, a measuring tape, a laser positioning device, an ultrasonic positioning device, a radar wave positioning device, a GPS positioning device, and an image positioning device. In some embodiments, the SASA 10 moves along the scanning path 71 within the to-be-tested area 70 by the positioning function of the positioning portion 20. In a preferred embodiment, the first MFS 1, the second MFS 2, the third MFS 3, and the fourth MFS 4 can simultaneously measure magnetic field, and the positioning portion 20 can simultaneously record the position when measuring magnetic field. Therefore, each element of the **[BUC1],** the **[BUC2],** the **[BUC3],** and the

[BUC4] is corresponding to one element of the [PS] of the measured positions.

In some embodiments, the Step B comprises following steps of: calculating a first magnetic field measurement distribution **BCD1** (hereinafter, referred to as "BCD1") from the [PS] and a subtraction of the **BInst1** from the **[BUC1];** calculating a second magnetic field measurement distribution **BCD2** (hereinafter, referred to as "BCD2") from the [PS] and a subtraction of the **BInst2** from the **[BUC2];** calculating a third magnetic field measurement distribution **BCD3** (hereinafter, referred to as "BCD3") from the [PS] and a subtraction of the **BInst3** from the **[BUC3];** calculating a fourth magnetic field measurement distribution **BCD4** (hereinafter, referred to as "BCD4") from the [PS] and a subtraction of the **BInst4** from the **[BUC4];** and calculating the magnetic field variation distribution **BVarD** from the **BCD1,** the **BCD2,** the **BCD3,** and the **BCD4.**

In some embodiments, the first MFS 1, the second MFS 2, the third MFS 3, and the fourth MFS 4 are located respectively at four vertices of an equilateral-triangle-based pyramid. In some other embodiments, the first MFS 1, the second MFS 2, the third MFS 3, and the fourth MFS 4 are located respectively at four vertices of a regular tetrahedron.

Please refer to Figure 9, which is a schematic perspective view showing another embodiment of a scanning artificial structure apparatus of the present invention. The main structure of the embodiment of Figure 9 is basically the same as the structure of the embodiment of Figure 1, except that the magnetic field sensing portion 50 further comprises a fifth MFS 5, a sixth MFS 6, a seventh MFS 7, and an eighth MFS 8, wherein the first MFS 1, the second MFS 2, the third MFS 3, the fourth MFS 4, the fifth MFS 5, the sixth MFS 6, the seventh MFS 7, and the eighth MFS 8 are located respectively at eight vertices of a regular hexahedron (non-coplanar configured). In current embodiment, the method for scanning artificial structure the present invention comprises following steps of: Step A: moving the SASA 10 along the scanning path 71 within the to-be-tested area 70, in the meantime, measuring magnetic field by the first MFS 1, the second MFS 2, the third MFS 3, the fourth MFS 4, the fifth MFS 5, the sixth MFS 6, the seventh MFS 7, and the eighth MFS 8, respectively, and recording a position sequence [PS], wherein the **[BUC1]** is measured by the first MFS 1, the **[BUC2]** is measured by the second MFS 2, the **[BUC3]** is measured by the third MFS 3, the **[BUC4]** is measured by the fourth MFS 4. the **[BUC5]** is measured by the fifth MFS, the sequence **[BUC6]** is measured by the sixth MFS, the **[BUC7]** is measured by the seventh MFS, and the **[BUC8]** is measured by the eighth MFS; and Step B: calculating a magnetic field variation distribution **BVarD** from the **[BUC1]**, the **[BUC2]**, the **[BUC3]**, the **[BUC4]**, the **[BUC5]**, the **[BUC6],** the **[BUC7],** the **[BUC8],** and the [PS], wherein the magnetic field variation distribution **BVarD** is corresponding to an artificial structure distribution. In current embodiments, the magnetic field variation distribution **BVarD** is a magnetic field gradient-vector-magnitude distribution (scalar) which combines the [PS] and a magnetic field gradient-vector-magnitude sequence (scalar sequence) calculated from the **[BUC1],** the **[BUC2],** the **[BUC3],** the **[BUC4],** the **[BUC5]**, the **[BUC6],** the **[BUC7],** and the **[BUC8]**. In some embodiments, the magnetic field variation distribution **BVarD** is a magnetic field gradient-vector distribution (vector) which combines the [PS] and a magnetic field gradient-vector sequence (vector sequence) calculated from the **[BUC1]**, the **[BUC2]**, the **[BUC3]**, the **[BUC4],** the **[BUC5]**, the **[BUC6]**, the **[BUC7],** and the **[BUC8]**. In some embodiments, the magnetic field variation distribution **BVarD** is a magnetic field gradient-vector-horizontal-component distribution (vector) which combines the [PS] and a magnetic field gradient-vector-horizontal-component sequence (vector sequence) calculated from the **[BUC1]**, the **[BUC2]**, the **[BUC3]**, the **[BUC4],** the **[BUC5]**, the **[BUC6]**, the **[BUC7],** and the **[BUC8]**. In some embodiments, the magnetic field variation distribution **BVarD** is a magnetic field gradient-vector-horizontal-component-magnitude distribution (scalar) which combines the [PS] and a magnetic field gradient-vector-horizontal-component-magnitude sequence (scalar sequence) calculated from the **[BUC1]**, the **[BUC2],** the **[BUC3],** the **[BUC4],** the **[BUC5]**, the **[BUC6]**, the **[BUC7],** and the **[BUC8]**. To calculated the magnetic field variation distribution **BVarD** from the **[BUC1]**, the **[BUC2]**, the **[BUC3]**, the **[BUC4]**, the **[BUC5]**, the **[BUC6],** the **[BUC7],** the **[BUC8]** and the [PS] of the measured positions are not limited to the above method. It is easy to calculate the magnetic field variation distribution **BVarD** when the **[BUC1],** the **[BUC2]**, the **[BUC3]**, the **[BUC4],** the **[BUC5]**, the **[BUC6],** the **[BUC7]**, the **[BUC8]** and the [PS] of the measured positions are known.

In some embodiments, the magnetic field sensing portion 50 comprises four magnetic field sensors or more than four magnetic field sensors, wherein at least four of the magnetic field sensors of the magnetic field sensing portion 50 are non-coplanar configured.

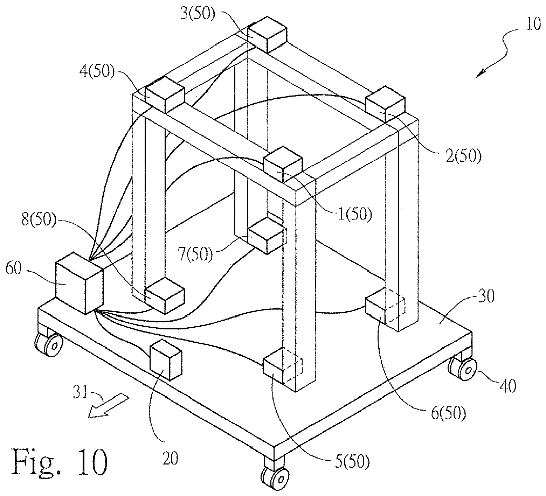

Please refer to Figure 10, which is a schematic perspective view showing another embodiment of a scanning artificial structure apparatus of the present invention. The main structure of the embodiment of Figure 10 is basically the same as the structure of the embodiment of Figure 3, except that the magnetic field sensing portion 50 further comprises a fifth MFS 5, a sixth MFS 6, a seventh MFS 7, and an eighth MFS 8, wherein the first MFS 1, the second MFS 2, the third MFS 3, the fourth MFS 4, the fifth MFS 5, the sixth MFS 6, the seventh MFS 7, and the eighth MFS 8 are located respectively at eight vertices of a regular hexahedron (this part is the same as the embodiment of Figure 9). The positioning portion 20, the first MFS 1, the second MFS 2, the third MFS 3, the fourth MFS 4, the fifth MFS 5, the sixth MFS 6, the seventh MFS 7, and the eighth MFS 8 are connected respectively to the data processing portion 60 by wire. The data processing portion 60 is used for recording the magnetic field data measured by the first MFS 1, the second MFS 2, the third MFS 3, the fourth MFS 4, the fifth MFS 5, the sixth MFS 6, the seventh MFS 7, and the eighth MFS 8 and the position data from the positioning portion 20 (or used for recording the data and processing the data). Please also refer to Figure 11, which is a schematic view showing three axes of each of the magnetic field sensors of the magnetic field sensing portion of the embodiment of the scanning artificial structure apparatus of Figure 10. Each of the magnetic field sensors of the magnetic field sensing portion 50 has three axes. For example, the first MFS 1 has a **X1** axis, a **Y1** axis, and a **Z1** axis; the second MFS 2 has a **X2** axis, a **Y2** axis, and a **Z2** axis; the third MFS 3 has a **X3** axis, a **Y3** axis, and a **Z3** axis; the fourth MFS 4 has a **X4** axis, a **Y4** axis, and a **Z4** axis; the fifth MFS 5 has a **X5** axis, a **Y5** axis, and a **Z5** axis; the sixth MFS 6 has a **X6** axis, a **Y6** axis, and a **Z6** axis; the seventh MFS 7 has a **X7** axis, a **Y7** axis, and a **Z7** axis; the eighth MFS 8 has a **X8** axis, a **Y8** axis, and a **Z8** axis. Similarly, the SASA 10 of the present invention may generate the **BInst**, especially when the moving portion 40 is the steerable wheels with motor power. The operation of the motor may generate a magnetic field. The **BInst** can cause interference to each of the magnetic field sensors of the magnetic field sensing portion 50. Therefore, the interference of the **BInst** to each of the magnetic field sensors of the magnetic field sensing portion 50 must be removed. Hence, in current embodiments, the method for scanning artificial structure of the present invention basically has the same steps as the method in the embodiment of Figure 9, except that it further comprises a following step of: Step A0: measuring the **BInst** generated by the SASA 10 by the first MFS 1, the second MFS 2, the third MFS 3, the fourth MFS 4, the fifth MFS 5, the sixth MFS 6, the seventh MFS 7, and the eighth MFS 8, respectively, wherein the **BInst1,** the **BInst2,** the **BInst3,** the **BInst4,** a **BInstS,** a **BInst6,** a **BInst7,** a **BInst8** are measured by the first MFS 1, the second MFS 2, the third MFS 3, the fourth MFS 4, the fifth MFS 5, the sixth MFS 6, the seventh MFS 7, and the eighth MFS 8. In the Step B, the magnetic field variation distribution **BVarD** is calculated from a subtraction of the **BInst1** from the **[BUC1]**, a subtraction of the **BInst2** from the **[BUC2],** a subtraction of the **BInst3** from the **[BUC3],** a subtraction of the **BInst4** from the **[BUC4],** a subtraction of the **BInstS** from the **[BUC5]**, a subtraction of the **BInst6** from the **[BUC6],** a subtraction of the **BInst7** from the **[BUC7],** a subtraction of the **BInst8** from the **[BUC8],** and the [PS]. Thereby the interference to the first MFS 1, the second MFS 2, the third MFS 3, the fourth MFS 4, the fifth MFS 5, the sixth MFS 6, the seventh MFS 7, and the eighth MFS 8 caused by the **BInst** can be removed, respectively. The method for scanning artificial structure of the present invention is executed in following sequence: (1) the Step A0, the Step A, and the Step B, or (2) the Step A, the Step A0, and the Step B.

Please refer to the description above for the steps of using the first MFS 1, the second MFS 2, the third MFS 3, and the fourth MFS 4 to measure the **BInst** generated by the SASA 10 in the Step A0. Similarly, in the Step A0, to use the fifth MFS 5 to measure the **BInst** generated by the SASA 10 comprises following steps of: Step A51: rotating the SASA 10 around the first axis (the **Z5** axis) of the fifth MFS 5 by at least 180 degrees, in the meantime, measuring magnetic field by the fifth MFS 5, wherein a fifth-magnetic-field-sensor-first-axis measurement sequence **[BZ5]** (sequence of vectors) is measured by the fifth MFS 5; Step A52: rotating the SASA 10 around the second axis (the **X5** axis) of the fifth MFS 5 by at least 180 degrees, in the meantime, measuring magnetic field by the fifth MFS 5, wherein a fifth-magnetic-field-sensor-second-axis measurement sequence **[BX5]** (sequence of vectors) is measured by the fifth MFS 5, wherein the second axis of the fifth MFS 5 is orthogonal to the first axis of the fifth MFS 5; and Step A53: calculating the **BInstS** from the **[BZ5]** and the **[BX5]**. In the Step A0, to use the sixth MFS 6 to measure the **BInst** generated by the SASA 10 comprises following steps of: Step A61: rotating the SASA 10 around the first axis (the **Z6** axis) of the sixth MFS 6 by at least 180 degrees, in the meantime, measuring magnetic field by the sixth MFS 6, wherein a sixth-magnetic-field-sensor-first-axis measurement sequence **[BZ6]** (sequence of vectors) is measured by the sixth MFS 6; Step A62: rotating the SASA 10 around the second axis (the **X6** axis) of the sixth MFS 6 by at least 180 degrees, in the meantime, measuring magnetic field by the sixth MFS 6, wherein a sixth-magnetic-field-sensor-second-axis measurement sequence **[BX6]** (sequence of vectors) is measured by the sixth MFS 6, wherein the second axis of the sixth MFS 6 is orthogonal to the first axis of the sixth MFS 6; and Step A63: calculating the **BInst6** from the **[BZ6]** and the **[BX6].** In the Step A0, to use the seventh MFS 7 to measure the **BInst** generated by the SASA 10 comprises following steps of: Step A71: rotating the SASA 10 around the first axis (the **Z7** axis) of the seventh MFS 7 by at least 180 degrees, in the meantime, measuring magnetic field by the seventh MFS 7, wherein a seventh-magnetic-field-sensor-first-axis measurement sequence **[BZ7]** (sequence of vectors) is measured by the seventh MFS 7; Step A72: rotating the SASA 10 around the second axis (the **X7** axis) of the seventh MFS 7 by at least 180 degrees, in the meantime, measuring magnetic field by the seventh MFS 7, wherein a seventh-magnetic-field-sensor-second-axis measurement sequence **[BX7]** (sequence of vectors) is measured by the seventh MFS 7, wherein the second axis of the seventh MFS 7 is orthogonal to the first axis of the seventh MFS 7; and Step A73: calculating the **BInst7** from the **[BZ7]** and the **[BX7].** In the Step A0, to use the eighth MFS 8 to measure the **BInst** generated by the SASA 10 comprises following steps of: Step A81: rotating the SASA 10 around the first axis (the **Z8** axis) of the eighth MFS 8 by at least 180 degrees, in the meantime, measuring magnetic field by the eighth MFS 8, wherein an eighth-magnetic-field-sensor-first-axis measurement sequence **[BZ8]** (sequence of vectors) is measured by the eighth MFS 8; Step A82: rotating the SASA 10 around the second axis (the **X8** axis) of the eighth MFS 8 by at least 180 degrees, in the meantime, measuring magnetic field by the eighth MFS 8, wherein an eighth-magnetic-field-sensor-second-axis measurement sequence **[BX8]** (sequence of vectors) is measured by the eighth MFS 8, wherein the second axis of the eighth MFS 8 is orthogonal to the first axis of the eighth MFS 8; and Step A83: calculating the **BInst8** from the **[BZ8]** and the **[BX8].**

In some embodiments, the Step B comprises following steps of: calculating the **BCD1** from the [PS] and a subtraction of the **BInst1** from the **[BUC1]**; calculating the **BCD2** from the [PS] and a subtraction of the **BInst2** from the **[BUC2]**; calculating the **BCD3** from the [PS] and a subtraction of the **BInst3** from the **[BUC3]**; calculating the **BCD4** from the [PS] and a subtraction of the **BInst4** from the **[BUC4]**; calculating a fifth magnetic field measurement distribution **BCD5** (hereinafter, referred to as "BCD5") from the [PS] and a subtraction of the **BInstS** from the **[BUC5]**; calculating a sixth magnetic field measurement distribution **BCD6** (hereinafter, referred to as "BCD6") from the [PS] and a subtraction of the **BInst6** from the **[BUC6]**; calculating a seventh magnetic field measurement distribution **BCD7** (hereinafter, referred to as "BCD7") from the [PS] and a subtraction of the **BInst7** from the **[BUC7]**; and calculating an eighth magnetic field measurement distribution **BCD8** (hereinafter, referred to as "BCD8") from the [PS] and a subtraction of the **BInst8** from the **[BUC8]**; and calculating the magnetic field variation distribution **BVarD** from the **BCD1,** the **BCD2,** the **BCD3,** the **BCD4,** the **BCD5,** the **BCD6,** the **BCD7,** and the **BCD8.**

In some embodiments, the first axis of the first MFS 1 may be the **Z1** axis or an axis almost coincident with the **Z1** axis, while the second axis of the first MFS 1 may be any axis orthogonal to the first axis of the first MFS 1. In some embodiments, the first axis of the second MFS 2 may be the **Z2** axis or an axis almost coincident with the **Z2** axis, while the second axis of the second MFS 2 may be any axis orthogonal to the first axis of the second MFS 2. In some embodiments, the first axis of the third MFS 3 may be the **Z3** axis or an axis almost coincident with the **Z3** axis, while the second axis of the third MFS 3 may be any axis orthogonal to the first axis of the third MFS 3. In some embodiments, the first axis of the fourth MFS 4 may be the **Z4** axis or an axis almost coincident with the **Z4** axis, while the second axis of the fourth MFS 4 may be any axis orthogonal to the first axis of the fourth MFS 4.

In some embodiments, the first axis of the first MFS 1 may be any axis, while the second axis of the first MFS 1 may be any axis orthogonal to the first axis of the first MFS 1. In some embodiments, the first axis of the second MFS 2 may be any axis, while the second axis of the second MFS 2 may be any axis orthogonal to the first axis of the second MFS 2. In some embodiments, the first axis of the third MFS 3 may be any axis, while the second axis of the third MFS 3 may be any axis orthogonal to the first axis of the third MFS 3. In some embodiments, the first axis of the fourth MFS 4 may be any axis, while the second axis of the fourth MFS 4 may be any axis orthogonal to the first axis of the fourth MFS 4.

In some embodiments, the first axis of the fifth MFS 5 may be the **Z5 axis** or an axis almost coincident with the **Z5** axis, while the second axis of the fifth MFS 5 may be any axis orthogonal to the first axis of the fifth MFS 5. In some embodiments, the first axis of the sixth MFS 6 may be the **Z6** axis or an axis almost coincident with the **Z6** axis, while the second axis of the sixth MFS 6 may be any axis orthogonal to the first axis of the sixth MFS 6. In some embodiments, the first axis of the seventh MFS 7 may be the **Z7** axis or an axis almost coincident with the **Z7** axis, while the second axis of the seventh MFS 7 may be any axis orthogonal to the first axis of the seventh MFS 7. In some embodiments, the first axis of the eighth MFS 8 may be the **Z8** axis or an axis almost coincident with the **Z8** axis, while the second axis of the eighth MFS 8 may be any axis orthogonal to the first axis of the eighth MFS 8.

In some embodiments, the first axis of the fifth MFS 5 may be any axis, while the second axis of the fifth MFS 5 may be any axis orthogonal to the first axis of the fifth MFS 5. In some embodiments, the first axis of the sixth MFS 6 may be any axis, while the second axis of the sixth MFS 6 may be any axis orthogonal to the first axis of the sixth MFS 6. In some embodiments, the first axis of the seventh MFS 7 may be any axis, while the second axis of the seventh MFS 7 may be any axis orthogonal to the first axis of the seventh MFS 7. In some embodiments, the first axis of the eighth MFS 8 may be any axis, while the second axis of the eighth MFS 8 may be any axis orthogonal to the first axis of the eighth MFS 8.

In some embodiments, the first MFS 1, the second MFS 2, the third MFS 3, the fourth MFS 4, the fifth MFS 5, the sixth MFS 6, the seventh MFS 7, and the eighth MFS 8 are connected to the data processing portion 60 respectively by wireless connection. In some embodiments, the first MFS 1, the second MFS 2, the third MFS 3, the fourth MFS 4, the fifth MFS 5, the sixth MFS 6, the seventh MFS 7, and the eighth MFS 8 are located respectively at eight vertices of a parallelepiped. In some other embodiments, the first MFS 1, the second MFS 2, the third MFS 3, the fourth MFS 4, the fifth MFS 5, the sixth MFS 6, the seventh MFS 7, and the eighth MFS 8 are located respectively at eight vertices of a cuboid. In some embodiments, the first MFS 1, the second MFS 2, the third MFS 3, the fourth MFS 4, the fifth MFS 5, the sixth MFS 6, the seventh MFS 7, and the eighth MFS 8 are located respectively at eight vertices of a regular hexahedron.

Hence, the method for scanning artificial structure of the present invention can indeed scan the corresponding artificial structure distribution under the to-be-tested area 70, so as to facilitate the avoidance of these artificial structures during construction mining. And the feature of the present invention is that the first MFS 1, the second MFS 2, the third MFS 3, the fourth MFS 4, the fifth MFS 5, the sixth MFS 6, the seventh MFS 7, and the eighth MFS 8 of the present invention can be the semiconductor chip type magnetic field sensor which is very cheap, but is sufficient for the needs of the method for scanning artificial structure of the present invention.

As disclosed in the above description and attached drawings, the present invention can provide an apparatus and method for scanning artificial structure. It is new and can be put into industrial use.

Although the embodiments of the present invention have been described in detail, many modifications and variations may be made by those skilled in the art from the teachings disclosed hereinabove. Therefore, it should be understood that any modification and variation equivalent to the spirit of the present invention be regarded to fall into the scope defined by the appended claims.

**Claims**

1. A method for scanning artificial structure, wherein a scanning artificial structure apparatus comprises a magnetic field sensing portion, wherein said magnetic field sensing portion comprises a first magnetic field sensor, a second magnetic field sensor, a third magnetic field sensor, and a fourth magnetic field sensor, wherein said first magnetic field sensor, said second magnetic field sensor, said third magnetic field sensor, and said fourth magnetic field sensor are non-coplanar configured, said method comprises following steps of:

   Step A: moving said scanning artificial structure apparatus along a scanning path within a to-be-tested area, in the meantime, measuring magnetic field by said first magnetic field sensor, said second magnetic field sensor, said third magnetic field sensor, and said fourth magnetic field sensor respectively, and recording a position sequence when measuring magnetic field, wherein a first magnetic field measurement sequence is measured by said first magnetic field sensor, a second magnetic field measurement sequence is measured by said second magnetic field sensor, a third magnetic field measurement sequence is measured by said third magnetic field sensor, and a fourth magnetic field measurement sequence is measured by said fourth magnetic field sensor; and
   Step B: calculating a magnetic field variation distribution from said first magnetic field measurement sequence, said second magnetic field measurement sequence, said third magnetic field measurement sequence, said fourth magnetic field measurement sequence, and said position sequence, wherein said magnetic field variation distribution is corresponding to at least one artificial structure distribution.

2. The method for scanning artificial structure according to claim 1, further comprising a following step of:
   Step A0: measuring an instrument magnetic field by said first magnetic field sensor, said second magnetic field sensor, said third magnetic field sensor, and said fourth magnetic field sensor respectively, wherein said instrument magnetic field is generated by said scanning artificial structure apparatus, wherein a first instrument magnetic field measurement is measured by said first magnetic field sensor, a second instrument magnetic field measurement is measured by said second magnetic field sensor, a third instrument magnetic field measurement is measured by said third magnetic field sensor, and a fourth instrument magnetic field measurement is measured by said fourth magnetic field sensor; wherein in said Step B, said magnetic field variation distribution is calculated from a subtraction of said first instrument magnetic field measurement from said first magnetic field measurement sequence, a subtraction of said second instrument magnetic field measurement from said second magnetic field measurement sequence, a subtraction of said third instrument magnetic field measurement from said third magnetic field measurement sequence, a subtraction of said fourth instrument magnetic field measurement from said fourth magnetic field measurement sequence, and said position sequence; wherein said method is executed in following sequence: (1) said Step A0, said Step A, and said Step B, or (2) said Step A, said Step A0, and said Step B.

3. The method for scanning artificial structure according to claim 1, wherein said magnetic field sensing portion further comprises a fifth magnetic field sensor, a sixth magnetic field sensor, a seventh magnetic field sensor, and an eighth magnetic field sensor, wherein said Step A further comprises a following step of: measuring magnetic field by said fifth magnetic field sensor, said sixth magnetic field sensor, said seventh magnetic field sensor, and said eighth magnetic field sensor respectively during moving said scanning artificial structure apparatus, wherein a fifth magnetic field measurement sequence is measured by said fifth magnetic field sensor, a sixth magnetic field measurement sequence is measured by said sixth magnetic field sensor, a seventh magnetic field measurement sequence is measured by said seventh magnetic field sensor, and an eighth magnetic field measurement sequence is measured by said eighth magnetic field sensor; wherein in said Step B, said magnetic field variation distribution is calculated from said first magnetic field measurement sequence, said second magnetic field measurement sequence, said third magnetic field measurement sequence, said fourth magnetic field measurement sequence, said fifth magnetic field measurement sequence, said sixth magnetic field measurement sequence, said seventh magnetic field measurement sequence, said eighth magnetic field measurement sequence, and said position sequence.

4. The method for scanning artificial structure according to claim 3, further comprising a following step of:
   Step A0: measuring an instrument magnetic field by said first magnetic field sensor, said second magnetic field sensor, said third magnetic field sensor, said fourth magnetic field sensor, said fifth magnetic field sensor, said sixth magnetic field sensor, said seventh magnetic field sensor, and said eighth magnetic field sensor respectively, wherein said instrument magnetic field is generated by said scanning artificial structure apparatus, wherein a first instrument magnetic field measurement is measured by said first magnetic field sensor, a second instrument magnetic field measurement is measured by said second magnetic field sensor, a third instrument magnetic field measurement is measured by said third magnetic field sensor, a fourth instrument magnetic field measurement is measured by said fourth magnetic field sensor, a fifth instrument magnetic field measurement is measured by said fifth magnetic field sensor, a sixth instrument magnetic field measurement is measured by said sixth magnetic field sensor, a seventh instrument magnetic field measurement is measured by said seventh magnetic field sensor, and an eighth instrument magnetic field measurement is measured by said eighth magnetic field sensor; wherein in said Step B, said magnetic field variation distribution is calculated from a subtraction of said first instrument magnetic field measurement from said first magnetic field measurement sequence, a subtraction of said second instrument magnetic field measurement from said second magnetic field measurement sequence, a subtraction of said third instrument magnetic field measurement from said third magnetic field measurement sequence, a subtraction of said fourth instrument magnetic field measurement from said fourth magnetic field measurement sequence, a subtraction of said fifth instrument magnetic field measurement from said fifth magnetic field measurement sequence, a subtraction of said sixth instrument magnetic field measurement from said sixth magnetic field measurement sequence, a subtraction of said seventh instrument magnetic field measurement from said seventh magnetic field measurement sequence, a subtraction of said eighth instrument magnetic field measurement from said eighth magnetic field measurement sequence, and said position sequence; wherein said method is executed in following sequence: (1) said Step A0, said Step A, and said Step B, or (2) said Step A, said Step A0, and said Step B.

5. The method for scanning artificial structure according to claim 4, wherein in said Step A0, measuring said instrument magnetic field by said fifth magnetic field sensor comprises following steps of:

Step A51: rotating said scanning artificial structure apparatus around a first axis of said fifth magnetic field sensor by at least 180 degrees, in the meantime, measuring magnetic field by said fifth magnetic field sensor, wherein a fifth-magnetic-field-sensor-first-axis measurement sequence is measured by said fifth magnetic field sensor;

Step A52: rotating said scanning artificial structure apparatus around a second axis of said fifth magnetic field sensor by at least 180 degrees, in the meantime, measuring magnetic field by said fifth magnetic field sensor, wherein a fifth-magnetic-field-sensor-second-axis measurement sequence is measured by said fifth magnetic field sensor, wherein said first axis of said fifth magnetic field sensor and said second axis of said fifth magnetic field sensor are orthogonal; and

Step A53: calculating said fifth instrument magnetic field measurement from said fifth-magnetic-field-sensor-first-axis measurement sequence and said fifth-magnetic-field-sensor-second-axis measurement sequence;

wherein measuring said instrument magnetic field by said sixth magnetic field sensor comprises following steps of:

Step A61: rotating said scanning artificial structure apparatus around a first axis of said sixth magnetic field sensor by at least 180 degrees, in the meantime, measuring magnetic field by said sixth magnetic field sensor, wherein a sixth-magnetic-field-sensor-first-axis measurement sequence is measured by said sixth magnetic field sensor;

Step A62: rotating said scanning artificial structure apparatus around a second axis of said sixth magnetic field sensor by at least 180 degrees, in the meantime, measuring magnetic field by said sixth magnetic field sensor, wherein a sixth-magnetic-field-sensor-second-axis measurement sequence is measured by said sixth magnetic field sensor, wherein said first axis of said sixth magnetic field sensor and said second axis of said sixth magnetic field sensor are orthogonal; and

Step A63: calculating said sixth instrument magnetic field measurement from said sixth-magnetic-field-sensor-first-axis measurement sequence and said sixth-magnetic-field-sensor-second-axis measurement sequence;

wherein measuring said instrument magnetic field by said seventh magnetic field sensor comprises following steps of:

Step A71: rotating said scanning artificial structure apparatus around a first axis of said seventh magnetic field sensor by at least 180 degrees, in the meantime, measuring magnetic field by said seventh magnetic field sensor, wherein a seventh-magnetic-field-sensor-first-axis measurement sequence is measured by said seventh magnetic field sensor;

Step A72: rotating said scanning artificial structure apparatus around a second axis of said seventh magnetic field sensor by at least 180 degrees, in the meantime, measuring magnetic field by said seventh magnetic field sensor, wherein a seventh-magnetic-field-sensor-second-axis measurement sequence is measured by said seventh magnetic field sensor, wherein said first axis of said seventh magnetic field sensor and said second axis of said seventh magnetic field sensor are orthogonal; and

Step A73: calculating said seventh instrument magnetic field measurement from said seventh-magnetic-field-sensor-first-axis measurement sequence and said seventh-magnetic-field-sensor-second-axis measurement sequence;

wherein measuring said instrument magnetic field by said eighth magnetic field sensor comprises following steps of:

Step A81: rotating said scanning artificial structure apparatus around a first axis of said eighth magnetic field sensor by at least 180 degrees, in the meantime, measuring magnetic field by said eighth magnetic field sensor, wherein an eighth-magnetic-field-sensor-first-axis measurement sequence is measured by said eighth magnetic field sensor;

Step A82: rotating said scanning artificial structure apparatus around a second axis of said eighth magnetic field sensor by at least 180 degrees, in the meantime, measuring magnetic field by said eighth magnetic field sensor, wherein an eighth-magnetic-field-sensor-second-axis measurement sequence is measured by said eighth magnetic field sensor, wherein said first axis of said eighth magnetic field sensor and said second axis of said eighth magnetic field sensor are orthogonal; and

Step A83: calculating said eighth instrument magnetic field measurement from said eighth-magnetic-field-sensor-first-axis measurement sequence and said eighth-magnetic-field-sensor-second-axis measurement sequence.

6. The method for scanning artificial structure according to any one of claims 3-5, wherein said first magnetic field sensor, said second magnetic field sensor, said third magnetic field sensor, said fourth magnetic field sensor, said fifth magnetic field sensor, said sixth magnetic field sensor, said seventh magnetic field sensor, and said eighth magnetic field sensor are located respectively at eight vertices of a parallelepiped, located respectively at eight vertices of a cuboid, or located respectively at eight vertices of a regular hexahedron.

7. The method for scanning artificial structure according to any one of claims 2 and 4, wherein in said Step A0, measuring said instrument magnetic field by said first magnetic field sensor comprises following steps of:

Step A11: rotating said scanning artificial structure apparatus around a first axis of said first magnetic field sensor by at least 180 degrees, in the meantime, measuring magnetic field by said first magnetic field sensor, wherein a first-magnetic-field-sensor-first-axis measurement sequence is measured by said first magnetic field sensor;

Step A12: rotating said scanning artificial structure apparatus around a second axis of said first magnetic field sensor by at least 180 degrees, in the meantime, measuring magnetic field by said first magnetic field sensor, wherein a first-magnetic-field-sensor-second-axis measurement sequence is measured by said first magnetic field sensor, wherein said first axis of said first magnetic field sensor and said second axis of said first magnetic field sensor are orthogonal; and

Step A13: calculating said first instrument magnetic field measurement from said first-magnetic-field-sensor-first-axis measurement sequence and said first-magnetic-field-sensor-second-axis measurement sequence;

wherein measuring said instrument magnetic field by said second magnetic field sensor comprises following steps of:

Step A21: rotating said scanning artificial structure apparatus around a first axis of said second magnetic field sensor by at least 180 degrees, in the meantime, measuring magnetic field by said second magnetic field sensor, wherein a second-magnetic-field-sensor-first-axis measurement sequence is measured by said second magnetic field sensor;

Step A22: rotating said scanning artificial structure apparatus around a second axis of said second magnetic field sensor by at least 180 degrees, in the meantime, measuring magnetic field by said second magnetic field sensor, wherein a second-magnetic-field-sensor-second-axis measurement sequence is measured by said second magnetic field sensor, wherein said first axis of said second magnetic field sensor and said second axis of said second magnetic field sensor are orthogonal; and

Step A23: calculating said second instrument magnetic field measurement from said second-magnetic-field-sensor-first-axis measurement sequence and said second-magnetic-field-sensor-second-axis measurement sequence;

wherein measuring said instrument magnetic field by said third magnetic field sensor comprises following steps of:

Step A31: rotating said scanning artificial structure apparatus around a first axis of said third magnetic field sensor by at least 180 degrees, in the meantime, measuring magnetic field by said third magnetic field sensor, wherein a third-magnetic-field-sensor-first-axis measurement sequence is measured by said third magnetic field sensor;

Step A32: rotating said scanning artificial structure apparatus around a second axis of said third magnetic field sensor by at least 180 degrees, in the meantime, measuring magnetic field by said third magnetic field sensor, wherein a third-magnetic-field-sensor-second-axis measurement sequence is measured by said third magnetic field sensor, wherein said first axis of said third magnetic field sensor and said second axis of said third magnetic field sensor are orthogonal; and

Step A33: calculating said third instrument magnetic field measurement from said third-magnetic-field-sensor-first-axis measurement sequence and said third-magnetic-field-sensor-second-axis measurement sequence;

wherein measuring said instrument magnetic field by said fourth magnetic field sensor comprises following steps of:

Step A41: rotating said scanning artificial structure apparatus around a first axis of said fourth magnetic field sensor by at least 180 degrees, in the meantime, measuring magnetic field by said fourth magnetic field sensor, wherein a fourth-magnetic-field-sensor-first-axis measurement sequence is measured by said fourth magnetic field sensor;

Step A42: rotating said scanning artificial structure apparatus around a second axis of said fourth magnetic field sensor by at least 180 degrees, in the meantime, measuring magnetic field by said fourth magnetic field sensor, wherein a fourth-magnetic-field-sensor-second-axis measurement sequence is measured by said fourth magnetic field sensor, wherein said first axis of said fourth magnetic field sensor and said second axis of said fourth magnetic field sensor are orthogonal; and

Step A43: calculating said fourth instrument magnetic field measurement from said fourth-magnetic-field-sensor-first-axis measurement sequence and said fourth-magnetic-field-sensor-second-axis measurement sequence.

8. The method for scanning artificial structure according to any one of claims 1, 2 and 7, wherein said first magnetic field sensor, said second magnetic field sensor, said third magnetic field sensor, and said fourth magnetic field sensor are located respectively at four vertices of an equilateral-triangle-based pyramid or located respectively at four vertices of a regular tetrahedron.

9. The method for scanning artificial structure according to any one of claims 1-8, wherein said magnetic field variation distribution is a magnetic field gradient-vector distribution, a magnetic field gradient-vector-magnitude distribution, a magnetic field gradient-vector-horizontal-component distribution, or a magnetic field gradient-vector-horizontal-component-magnitude distribution.

10. A scanning artificial structure apparatus comprising:

a magnetic field sensing portion, wherein said magnetic field sensing portion comprises a first magnetic field sensor, a second magnetic field sensor, a third magnetic field sensor, and a fourth magnetic field sensor, wherein said first magnetic field sensor, said second magnetic field sensor, said third magnetic field sensor, and said fourth magnetic field sensor are non-coplanar configured; and

wherein said scanning artificial structure apparatus is for performing said method for scanning artificial structure according to any one of claims 1, 2, and 7-9.

11. The scanning artificial structure apparatus according to claim 10, wherein said magnetic field sensing portion further comprises a fifth magnetic field sensor, a sixth magnetic field sensor, a seventh magnetic field sensor, and an eighth magnetic field sensor, wherein said scanning artificial structure apparatus is for performing said method for scanning artificial structure according to any one of claims 3-6.

12. The scanning artificial structure apparatus according to claim 11, wherein said first magnetic field sensor, said second magnetic field sensor, said third magnetic field sensor, said fourth magnetic field sensor, said fifth magnetic field sensor, said sixth magnetic field sensor, said seventh magnetic field sensor, and said eighth magnetic field sensor are located respectively at eight vertices of a parallelepiped, located respectively at eight vertices of a cuboid, or located respectively at eight vertices of a regular hexahedron.

13. The scanning artificial structure apparatus according to claim 10, wherein said first magnetic field sensor, said second magnetic field sensor, said third magnetic field sensor, and said fourth magnetic field sensor are located respectively at four vertices of an equilateral-triangle-based pyramid or located respectively at four vertices of a regular tetrahedron.

14. The scanning artificial structure apparatus according to claim 10, further comprising a positioning portion.

15. The scanning artificial structure apparatus according to claim 14, wherein said positioning portion is one selected from the group consisting of: a ranging wheel, a distance measuring equipment, a rule, a measuring tape, a laser positioning device, an ultrasonic positioning device, a radar wave positioning device, a GPS positioning device, and an image positioning device.

Fig. 1

Fig. 2

Fig. 3

Fig. 4

Fig. 5

Fig. 6

Fig. 7A

Fig. 7B

Fig. 8

Fig. 9

Fig. 10

Fig. 11

Fig. 12 (Prior Art)

Europäisches
Patentamt

European
Patent Office

Office européen
des brevets

## EUROPEAN SEARCH REPORT

**Application Number**

EP 19 19 8020

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 888 353 B1 (WIEGERT ROY [US])<br>3 May 2005 (2005-05-03) | 1,3,6,<br>9-12,14,<br>15 | INV.<br>G01R33/00<br>G01R33/10 |
| Y | * columns 3-13; figures 5-8 * | 2,4,5,7,<br>8,13 | G01V3/08<br>G01V3/165<br>G01R33/02 |
| X | US 6 865 455 B1 (WIEGERT ROY F [US])<br>8 March 2005 (2005-03-08) | 1,8,9,<br>13-15 | |
| Y | * column 8 lines 10-38;<br>figure 6 * | 2,8,13 | ADD.<br>G01R33/022 |
| X | US 2017/315094 A1 (TIMMONS BRIAN P [US] ET AL) 2 November 2017 (2017-11-02)<br>* paragraphs [0030] - [0051]; figures 1-6 * | 1,2,8,9,<br>13-15 | |
| Y | WO 2015/031072 A1 (ANDREW LLC [US])<br>5 March 2015 (2015-03-05)<br>* paragraph [0036] * | 2,4,5,7 | |

| | TECHNICAL FIELDS SEARCHED (IPC) |
|---|---|
| | G01R<br>G01V |

The present search report has been drawn up for all claims

| Place of search | Date of completion of the search | Examiner |
|---|---|---|
| Munich | 20 February 2020 | Philipp, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 19 8020

This annex lists the patent family members relating to the patent documents cited in the above-mentioned European search report.
The members are as contained in the European Patent Office EDP file on
The European Patent Office is in no way liable for these particulars which are merely given for the purpose of information.

20-02-2020

| Patent document cited in search report | | | Publication date | Patent family member(s) | | Publication date |
|---|---|---|---|---|---|---|
| US 6888353 | B1 | | 03-05-2005 | NONE | | |
| US 6865455 | B1 | | 08-03-2005 | NONE | | |
| US 2017315094 | A1 | | 02-11-2017 | EP | 3314247 A2 | 02-05-2018 |
| | | | | US | 2017108469 A1 | 20-04-2017 |
| | | | | US | 2017315094 A1 | 02-11-2017 |
| | | | | US | 2019064115 A1 | 28-02-2019 |
| | | | | WO | 2017052712 A2 | 30-03-2017 |
| WO 2015031072 | A1 | | 05-03-2015 | EP | 2883272 A1 | 17-06-2015 |
| | | | | EP | 3121895 A1 | 25-01-2017 |
| | | | | US | 2016020504 A1 | 21-01-2016 |
| | | | | WO | 2015031072 A1 | 05-03-2015 |

EPO FORM P0459

For more details about this annex : see Official Journal of the European Patent Office, No. 12/82